(19) **Europäisches Patentamt**

**European Patent Office**

**Office européen des brevets**

(11) **EP 0 964 943 B1**

(12) **EUROPÄISCHE PATENTSCHRIFT**

(45) Veröffentlichungstag und Bekanntmachung des Hinweises auf die Patenterteilung:
**04.09.2002 Patentblatt 2002/36**

(51) Int Cl.[7]: **C30B 11/00**, C30B 33/00, C30B 29/22

(21) Anmeldenummer: **98913548.8**

(22) Anmeldetag: **14.02.1998**

(86) Internationale Anmeldenummer:
**PCT/EP98/00851**

(87) Internationale Veröffentlichungsnummer:
**WO 98/039502 (11.09.1998 Gazette 1998/36)**

(54) **VERFAHREN ZUR ZÜCHTUNG VON EINKRISTALLEN VON HOCHTEMPERATURSUPRALEITERN AUS SELTENERD-KUPRATEN DER FORM SE1+xBa2-xCu3O7-delta**

METHOD FOR GROWING MONOCRYSTALS OF HIGH-TEMPERATURE SUPRACONDUCTORS MADE OF RARE EARTH-CUPRATES OF FORM SE1+xBa2-xCu3O7-delta

PROCEDE DE CROISSANCE DE MONOCRISTAUX DE SUPRACONDUCTEURS HAUTE TEMPERATURE CUPRATES DE TERRES RARES DE LA FORME SE1+xBa2-xCu3O7-delta

(84) Benannte Vertragsstaaten:
**GB**

(30) Priorität: **04.03.1997 DE 19708711**

(43) Veröffentlichungstag der Anmeldung:
**22.12.1999 Patentblatt 1999/51**

(73) Patentinhaber: **Forschungszentrum Karlsruhe GmbH
76133 Karlsruhe (DE)**

(72) Erfinder: **WOLF, Thomas
D-76287 Rheinstetten (DE)**

(74) Vertreter: **Rückert, Friedrich, Dr.
Forschungszentrum Karlsruhe GmbH
Patente und Lizenzen
Weberstrasse 5
76133 Karlsruhe (DE)**

(56) Entgegenhaltungen:
**US-A- 5 079 220**

- **PATENT ABSTRACTS OF JAPAN vol. 095, no. 002, 31.März 1995 & JP 06 321693 A (SUMITOMO ELECTRIC IND LTD), 22.November 1994,**
- **KRAMER W E ET AL: "CRYSTAL GROWTH OF YBA2CU3O7 BY DIRECTIONAL FREEZING" JOURNAL OF CRYSTAL GROWTH, Bd. 94, Nr. 2, 1.Februar 1989, Seiten 572-578, XP000007508**
- **MURAKAMI M ET AL: "Melt-processed light rare earth element-Ba-Cu-O" SUPERCONDUCTOR SCIENCE & TECHNOLOGY, DEC. 1996, IOP PUBLISHING, UK, Bd. 9, Nr. 12, ISSN 0953-2048, Seiten 1015-1032, XP002068902**
- **YOO S I ET AL: "MELT PROCESSING FOR OBTAINING NDBA2CU3OY SUPERCONDUCTORS WITH HIGH TC AND LARGE JC" APPLIED PHYSICS LETTERS, Bd. 65, Nr. 5, 1.August 1994, Seiten 633-635, XP000464885**

**Beschreibung**

Die Erfindung betrifft ein Verfahren zur Herstellung von Hochtemperatursupraleitern aus Seltenerd (SE)-Kupraten der Form $SE_{1+x}Ba_{2-x}Gu_3O_{7-\delta}$ mit der SE/Ba-Fehlbesetzung x und der Sauerstoffreduktion δ, kurz SE123, Über einen Kristallisationsprozeß oder über einen Schmelztexturprozeß sowie SE123-Kristalle, die nach einem der beiden Verfahren hergestellt sind.

Mit solchen Hochtemperatursupraleitern werden hohe kritische Ströme I bzw Stromdichten j und Irreversibilitätsfelder $B_{irr}$ erreicht, mit denen supraleitende Permanentmagnete mit hohen Feldstärken hergestellt werden können.

Weltweit werden große Anstrengungen unternommen, SE123-Proben mit insbesondere SE = Nd herzustellen, die neben den o. e. elektromagnetischen Eigenschaften zusätzlich eine hohe Sprungtemperatur $T_c$ haben. Die Qualität bisher bekannter Nd123-Proben ist allerdings aus folgenden Gründen noch unbefriedigend:

- Die Startmischungen sind noch zu SE- bzw. Nd-reich.
- Die Temperaturintervalle während der Verfahren sind zu groß
- Die Sauerstoffpartialdrücke $p_{o2}$ während der Verfahren sind nicht angemessen.

Die Schmelztextur wird ähnlich wie bei Y123 durchgeführt, obwohl Nd123 eine andere Substanz ist. Die Zugabe von Nd422 zu Nd123 führt zu einem nicht kontrollierbaren Prozeßverlauf. Es ist völlig offen, ob die peritektische Reaktion im Nd-System ähnlich abläuft, wie im bekannten Y-System.

*In dem Dokument D1 = Patent abstracts of Japan, Vol. 095, No. 002, 31. März* 1995 *& JP 06 32 16 93 A (Sumitomo Electric Ind LTD), 22. November 1994, wird ein* Verfahren *zur Herstellung von Einkristallen von Hochtemperatursupraleitern aus Seltenerd-Cupraten der Form*

$$SE_{1+x}Ba_{2-x}Cu_3O_{7-d}$$

*offenbahrt. Das* verwendete *Startpulver ist SE-arm. Es ist daraus nicht zu entnehmen, welche Dotierstoffe in welcher Qualität dem Ausgangspulver beizufügen sind, um die Pinning-Eigenschaften zu züchten. Die Sauerstoffbeladung, um die Pinningeigenschaften vollends zu züchten, wird nicht beschrieben. Auch wird die Prozessierung der Schmelze nicht dargestellt.*

*Einen Schmelzprozeß in reduzierender Atmosphäre offenbahrt das Dokument D4 = Murakami M et al.: "Melt-processed light rare earth element Ba-Cu-O", Superconductor Science & Technology, Dec. 1996, IOP Publishing, UK, Bd. 9, Nr. 12, ISSN 0953-2048, Seiten 1015-1032. Nicht angegeben sind die Parameterberei-*

*che, die zur Erzielung der gewünschten HTSL-Eigenschaften eingehalten werden sollen.*

Der Erfindung liegt die Aufgabe zugrunde, Verfahren anzugeben, mit denen SE-Einkristalle bzw. Quasieinkristalle der Form SE123 mit geringer SE/Ba-Fehlbesetzung x gezüchtet werden können. Dabei sollen die Materialien eine hohe Sprungtemperatur $T_c$ eine hohe Stromdichte j sowie ein hohes Irreversibilitätsfeld $B_{irr}$ aufweisen.

Die Aufgabe wird durch zwei, nämlich über die Kristallisation (Anspruch 1) und das Schmelztexturverfahren (Anspruch 2) gelöst. Einkristalle und Schmelztexturproben der Form $SE_{1+x}Ba_{2-x}Cu_3O_{7-\delta}$ mit kleinem x im einstelligen Prozentbereich und geringem Sauerstoffdefizit δ, die nach einem der beiden Verfahren hergestellt werden, sind Bestandteil der Erfindung (Anspruch 6).

Die Startpulvermischungen sind durchweg SE-arm. Eine SE/Ba-Fehlbesetzung x wird dadurch weitestgehend verhindert, d. h. durch die Präparation bei hohen Temperaturen, Prozessieren unter reduziertem Sauerstoffpartialdruck $p_{O2}$ bzw. gezielter Einstellung desselben und grundsätzlicher Zusammensetzung der Startmischung innerhalb folgender Anteilsbereiche 1 - 3 at% $SE_1O_{3/2}$, 27 - 56 at% BaO (bzw. Nitrate oder Karbonate davon) und CuO. Die Stärke der SE/Ba-Fehlbesetzung x wird grundsätzlich durch das Phasendiagramm festgelegt und kann durch Beachtung des Erwähnten gesteuert werden. Die Kristallzüchtung ist ein reproduzierbarer, thermodynamischer Prozeß. Er führt über die komplette Schmelze, daher haben Korngröße, Morphologie, Mischungsgrad, Preßdruck, Dichte und dergleichen der Startpulverzusammensetzung keinen Einfluß beim Prozeß.

Geringe Beigaben von Y123 und SrO sind zur gezielten Erzeugung der Pinning-Eigenschaften notwendig.

Beim Kristall- und Schmelztexturprozeß ist wesentlich, daß beide bei hohen Temperaturen gestoppt werden, um die Zersetzung der SE123-Phase zu verhindern.

In den Ansprüchen 3 und 4 werden an sich bekannte Verfahrensschritte gekennzeichnet, die sich bei Schmelztexturprozessen bewährt haben. Zum einen betrifft es die Beigabe der oben aufgeführten Viskositätserhöher bzw. deren Vorstufen, zum andern betrifft es die Beigabe sog. Perowskite, die zur Verbesserung der Plastizität der Texturpellets dienen.

Die Seltenerd-Metalle, die für den Herstellungsprozeß von Bedeutung und in Anspruch 5 gekennzeichnet sind, sind La oder Nd oder Sm oder Eu oder Gd. Diese SE-Metallionen haben gleichzeitig die Neigung, einen Ba-Platz besetzen.

Mit den an das jeweils vorgesehene SE-Metallion modifizierten Verfahrensschritten lassen sich große Supraleiterkristalle und texturierte Quasieinkristalle mit jeweils hoher Sprungtemperatur $T_c$, hoher kritischer Stromdichte j und hohem Irreversibilitätsfeld $B_{irr}$ errei-

chen. Somit steht ein zuverlässiger, ausschußarmer Herstellungsprozeß zur Verfügung, mit dem im technischen Maßstab produziert werden kann. Das ist der Grundlagenforschung dienlich, die noch Umfangreiches zur Klärung der Phänome beizutragen hat. In der technischen Anwendung stehen damit supraleitende Substratmaterialien zur Verfügung, die technisch und wirtschaftlich vertretbar hergestellt werden können. Nach dem Kristallzüchtungsverfahren lassen sich ebenfalls Keimkristalle hoher Schmelztemperatur für die Schmelztextur anderer SE123-Kristalle herstellen.

Technischen Bereichen wie die Magnetlagertechnik für Schwungradspeicher, Motoren und Generatoren, aber auch zum Bau von Strombegrenzern und Stromzuführungen in der Hochstromtechnik als auch in der elektrischen Filtertechnik stehen damit Materialien mit weiterem Anwendungsspielraum und erhöhter Qualität zur Verfügung.

Die Erfindung wird im folgenden anhand des speziellen Seltenerd-Metalls Nd näher beschrieben und in den einzelnen Verfahrensschritten anhand der Zeichnung ausführlich erläutert. Es zeigen:

Figur 1 Stromdichte j in Abhängigkeit des Feldes B für verschiedene Sauerstoffreduktionswerte $\delta$,

Figur 2 Stromdichte j in Abhängigkeit des Feldes B für minimal reduziertes Nd123 bei verschiedenen Temperaturen $T < T_c$,

Figur 3 Sprungtemperatur $T_c$ in Abhängigkeit der Fehlbesetzung x bei Nd123,

Figur 4 Sprungtemperatur $T_c$ in Abhängigkeit der Sauerstoffreduktion $\delta$ für Y-, Gd-, Nd123 und Nd123 mit Fehlbesetzung,

Figur 5 Subsolidus-Phasendiagramm des Nd-Ba-Cu-O-Systems für $\leq 850\,^\circ$C und 1 bar Luftatmosphäre,

Figur 6 Stromdichte j und Relaxation S in Abhängigkeit des Magnetfelds B einer Y123-Probe,

Figur 7 Stromdichte j und Relaxation S in Abhängigkeit des Magnetfelds B einer Nd123-Probe.

Y123 war und ist noch Gegenstand intensiver Forschungsarbeiten und daher bisher am gründlichsten untersucht. Es gibt aber genügend Grund, die Verwendung von andern SE-Metallen in SE123-Kristallen zu untersuchen, da die begründete Annahme besteht, technisch noch günstigere Supraleitereigenschaften wie höhere Sprungtemperatur $T_c$, höhere Stromdichte j sowie ein höheres Irreversibilitätsfeld Birr zu erreichen.

Das Y läßt sich durch nahezu alle Seltenerd-Metalle substituieren. Dabei verändert sich die Metrik der Elementarzelle gemäß dem Ionenradius der entsprechenden Seltenerde. Dies führt zu einigen sehr wichtigen Veränderungen, wie am Beispiel von Nd unten beschrieben wird.

Der große Ionenradius von Nd erhöht die Stabilität der Verbindung Nd123. Zum Vergleich: die Schmelztemperatur von Y123 ist $T_{\text{Peritektikum, Y}} = 1010\,^\circ$C, von Nd123 jedoch $T_{\text{Peritektikum,Nd}} = 1080\,^\circ$C. Das ist auch der Grund, warum Nd123-Kristalle als Keimkristalle zur Züchtung anderer SE123-Kristalle verwendet werden.

Bekannt ist weiter, daß sich die maximale Sprungtemperatur $T_c$ mit wachsenden Ionenradius des SE-Metallions verändert. Daher hat z. B. Y123 die maximale Sprungtemperatur $T_{c,Y} = 92$ K und Nd123 $T_{c,Nd}$ = 96 K.

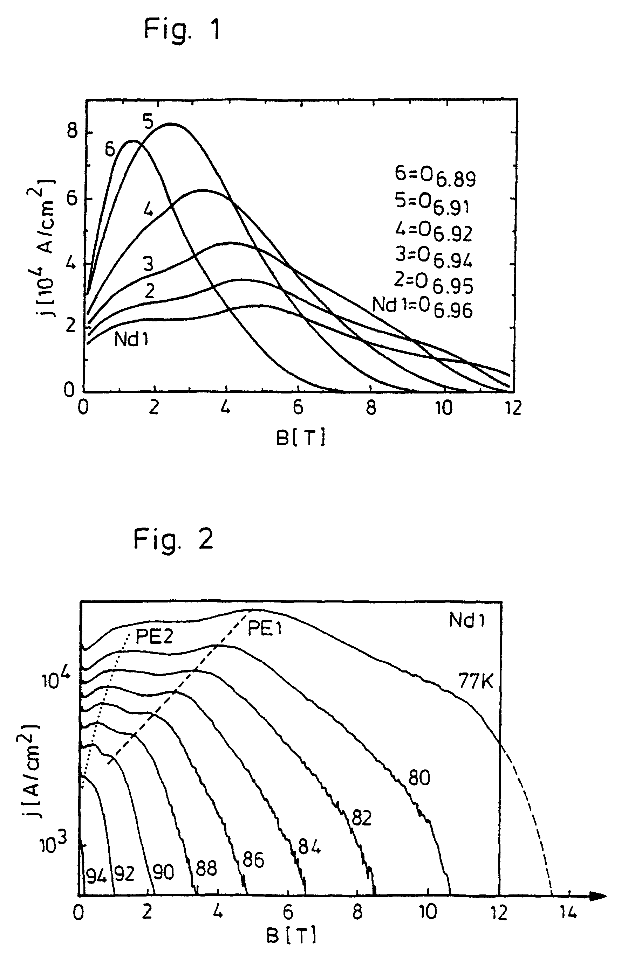

Bedeutungsvoll ist die Erhöhung der Sprungtemperatur von 92 K bei Y auf 96 K bei Nd. Damit einher geht eine drastische Erhöhung der kritischen Stromdichte j um das 2- bis 3-fache bei 77 K sowie des Irreversibilitätsfelds $B_{irr}$ um 1 bis 1.5 Tesla/K (siehe Figur 2).

Große Ionen wie Nd haben die Tendenz, das Ba in der Verbindung zu ersetzen. Solange diese Fehlbesetzung x unter 5 % bleibt, hat sie nur einen geringen Einfluß auf die Sprungtemperatur $T_c$. Eine größere Fehlbesetzung x führt jedoch zum starken Absenken der Sprungtemperatur $T_c$. Ein anerkanntes Modell für die höchsten Irreversibilitätsfelder $B_{irr}$ und Stromdichten j bzw. (Transport-) Ströme I ist bisher nicht vorhanden.

Die maximale Sprungtemperatur $T_c$ für Y123 wird bei einem Sauerstoffgehalt $O_{6.93}$ erreicht. Sie verschiebt sich je nach Ionenradius zu höheren (Nd123) oder kleineren (Yb123) Sauerstoffgehalten. Die Sauerstoffbeladung muß auf das verwendete SE-Metallion angepaßt werden, wegen der obigen Argumentation zum einen und wegen der unterschiedlichen Beladungsisothermen zum andern. Das ist auch ein Grund, warum sich Nd123-Kristalle als Substrate für supraleitende intergrierte Schaltkreise eignen.

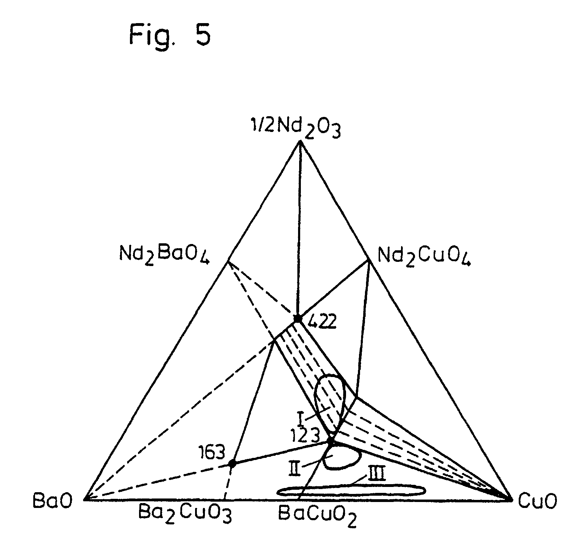

SE123 mit kleinen SE-Metallionen ist eine nahezu stöchiometrische Verbindung. SE123 mit größer werdenden SE-Metallionen besitzt dagegen eine immer ausgeprägtere Nichtstöchiometrie. Nd/Ba-Fehlbesetzungen x sind daher schnell eingehandelt. Sie werden aber durch gezielte, am Phasendiagramm (Figur 5) orientierte Verfahrensschritte niedrig gehalten, so daß die guten Supraleitereigenschaften des gemäß der beiden grundsätzlichen Verfahren erzeugten Kristalls bzw. Quasieinkristalls erreicht werden.

Der vierdimensionale (wegen der beteiligten Komponenten Nd, Ba, Cu, O) Homogenitätsbereich der Nd123-Phase ist nicht sehr geläufig. (Der Homogenitätsbereich ist im Subsolidus-Phasendiagramm (Figur 5) die vom SE- bzw. Nd123-Punkt ausgehende Linie, die das mit gestrichelten, geknickten Geraden durchzogene Feld durchschneidet. Die Nd/Ba-Fehlbesetzung geht von x = 0 entlang des Homogenitätsbereichs bis x = 0,9. Es ist allgemein anerkannt, daß der beste Supraleiter eine stöchiometrische Zusammensetzung der Kationen Nd : Ba : Cu = 1 : 2 : 3 aufweist. Hieraus wird deutlich welche Bedingungen, d. h. Verfahrensschritte getroffen werden müssen bzw. aufeinander zu folgen haben, um den Rand des Homogenitätsbereichs möglichst nahe an die Zusammensetzung 1 : 2 : 3 zu bringen. Es ist also unumgehbar, die chemische Zusammensetzung der Startmischung zu optimieren und die Temperatur als auch den Sauerstoffpartialdruck $p_{O2}$ prozeßabhängig optimal einzustellen. Geringere Fehlbesetzungen x werden nämlich bei geringeren Sauerstoffpartialdrücken $p_{O2}$, bei höherer Temperatur sowie bei Verwendung Ndarmer (allgemein SE-armer) sowie Cu/Ba-angepaßter Startmischungen erreicht Im Phasendiagramm sind dies die Starmischungsbereiche für die Kristallisation III und Schmelztextur II unterhalb des Punktes Nd123 (siehe Figur 5). Das Gebiet I im Phasendiagramm ist nicht mehr Nd-arm, es ist das Gebiet, an dem sich Startmischungs-Zusammensetzungen anderer Schmelztexturierer orientieren.

Das Phasendiagramm in Figur 5 ist in seiner inneren Form bei andern SE-Metallionen wie Nd nicht grundsätzlich verschieden, allerdings eben ionenspezifisch leicht modifiziert. Kleine SE-Metallionen bilden die in der Fachsprache "grüne" Phase SE211, große SE-Metallionen bilden die sog. "braune" Phase SE422 wegen der auffäligen, grünen bzw. braunen Farbe der jeweiligen Kristalle). Die zur SE123-Phase gehörige Liquidusfläche (Grenzfläche zwischen der völlig flüssigen und der gemischten Phase) der kleinen Ionensysteme sind steiler als die der großen. Die treibende Kraft für das Wachstum der SE123-Phase ist dadurch auch größer für große Ionenradien (siehe die Verfahrensschritte in Anspruch 1 und 2). Die Wachstumsgeschwindigkeit der SE123-Phase ist wesentlich größer bei großen SE-Metallionen als bei kleinen. Damit müssen die Abkühlintervalle in Abhängigkeit des prozessierten SE-Metallions durchgeführt werden. Richtung großer SE-Metallionen ergibt das zwar eine größer werdende Zeitersparnis, es ist aber darauf zu achten, daß eine störende Neukeimbildung vermieden wird.

In Figur 1 ist der Stromdichteverlauf in Abhängigkeit des Magnetfelds, j = f(B), für das Nd123-System bei verschiedener Sauerstoffreduktion δ und bei der Temperatur T von 77 K aufgetragen. Die Einstellung des $O_{7-δ}$-Gehalts ist für optimale Stromdichteverläufe j bei der technischen Anwendung von großer Bedeutung, da je nach Reservebedarf der "Arbeitspunkt", bestehend aus T, j, B entsprechend gelegt wird. Durch Variation des Sauerstoffgehalts von Nd123 wird der Verlauf j = f(B) beeinflußt. Für δ = 0, also völlige Oxidation, wird bei Kristallen eine verhältnismäßig kleine maximale Stromdichte $j_{max}$ von etwa 20 000 A/cm$^2$ bei 77 K und 4 Tesla erreicht. Dieser Maximalwert $j_{max}$ läßt sich mit δ > 0 weiter in die Höhe treiben, und zwar, wie die Kurve 5 in der Figur 1 zeigt, auf über 80 000 A/cm$^2$ bei B(T) etwa 2,5 T.

Die Kurve 1 in Figur 1 mit dem kleinsten Stromdichtemaximum hat noch recht deutlich zwei flache Maxima, die sich mit höher werdendem Stromdichtemaximum auf jeweils ein ausgeprägtes Maximum reduzieren. Die zwei Maxima PE1 und PE2, auch Doppel-Peak-Effekt genannt, rühren jeweils von punktartigen Defekten und der Zwillingsstruktur her. Das Maximum PE2 wird mit höherer Temperatur mehr betont, weil wegen der größer werdenden thermischen Aktivierung die Zwillinge die dominierenden Pinning-Defekte werden (PE2 und PE1 in Figur 2).

Für noch größere Sauerstoffreduktion $O_{7-δ}$ (δ ≥ 0,10), also $O_{6,90}$ geht die Maximalstromdichte $j_{max}$ wieder zurück, wie die Nd6-Kurve zeigt. Die Kurvenscharj = f(B, δ) zeigt das Auswahlpotential auf, wie die Kristalle bzw. Quasieinkristalle für den technischen Anwendungsfall "maßgeschneidert" werden müssen.

Für die Kurve 1 mit dem kleinsten Stromdichtemaximum wurde das Irreversibilitätsfeld $B_{irr}$ bei 13,4 T gemessen, für die Kurve mit dem höchsten Stromdichtemaximum bei etwa 9 T. Dabei war für die erstere die Reduktion δ = 0,04 und für die Zweite δ = 0,09, also $O_{6,96}$ bzw $O_{6,91}$.

Die maximale Stromdichte läßt sich noch experimentell reproduzierbar weiter erhöhen, wenn, wie in beiden Verfahren angegeben, der Startpulvermischung noch Sr oder Y (Kationen) beigegeben wird. Der derzeitige Rekordstromdichtewert, der dabei erhalten wird, liegt bei $j_{max}$ = 127 000 A/cm$^2$ und einem Feld B von 2 T. Das Irreversibilitätsfeld $B_{irr}$ ist dann bei 7 T.

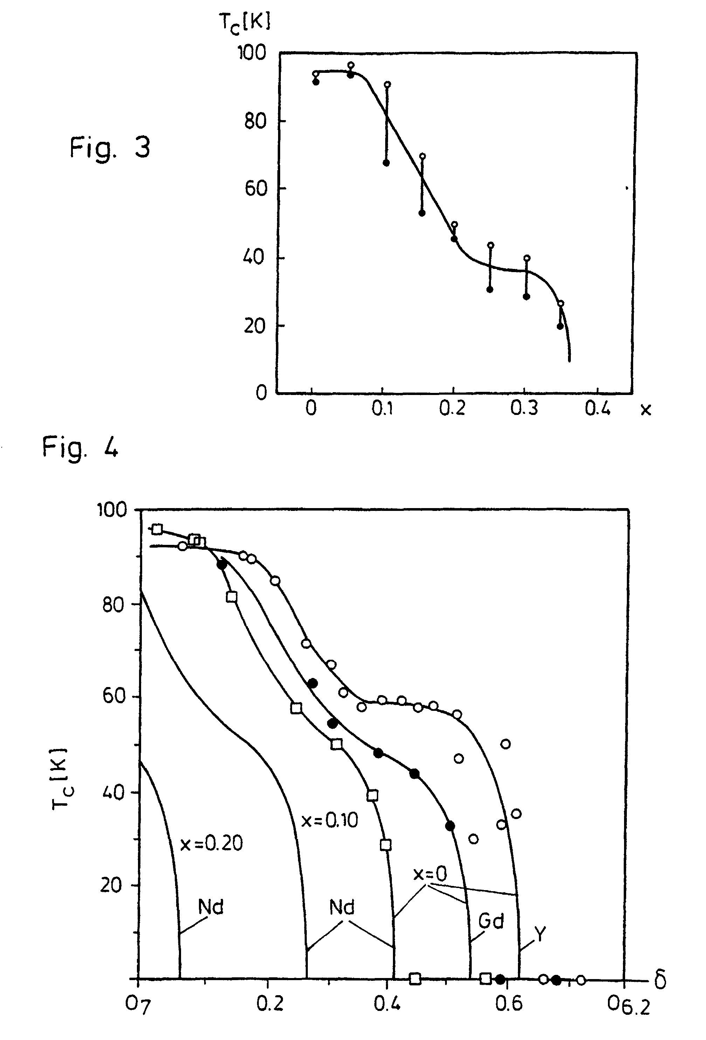

Figur 3 zeigt, um den bekannten Einfluß der Fehlbestezung hervorzuheben, die Sprungtemperatur $T_c$ in Abhängigkeit der Nd/Ba-Fehlbesetzung x bei einem voll oxidierten Nd123-System, also δ = 0 und damit $O_7$. Der orthorhombische zum tetragonalen Phasenübergang für völlig oxidierte Proben (δ = 0) geschieht etwa bei x = 0,25. Dann nimmt die Sprungtemperatur $T_c$ nichtlinear ab, bis schließlich die Supraleitfähigkeit bei etwa x = 0,4 verschwindet.

In Figur 4 ist die Sprungtemperatur $T_c$ in Abhängigkeit der Sauerstoffreduktion δ dargestellt. Von rechts nach links kommen zunächst die drei Verläufe für Y, Gd und Nd, jeweils ohne Fehlbesetzung x. Die restlichen zwei zeigen den Einfluß der Nd/Ba-Fehlbesetzung x, und zwar für x = 0,1 und 0,2.

Die in Figur 1 aufgenommenen Stromdichteverläufe des nicht fehlbesetzten Nd123-Systems offenbaren das große Potential solchermaßen hergestellter Kristalle bzw Quasieinkristalle für die Hochtemperatursupraleiteranwendung. Hohe Irreversibilitätsfelder $B_{irr}$, weit über den technisch notwendigen Magnetfeldern, wie sie für die Anwendung nötig sind, sind nicht die einzige Bedingung, für genügend hohe Stromdichten, sondern ebenfalls für tolerabel niedrige Verluste, die von thermischer Relaxation herrühren.

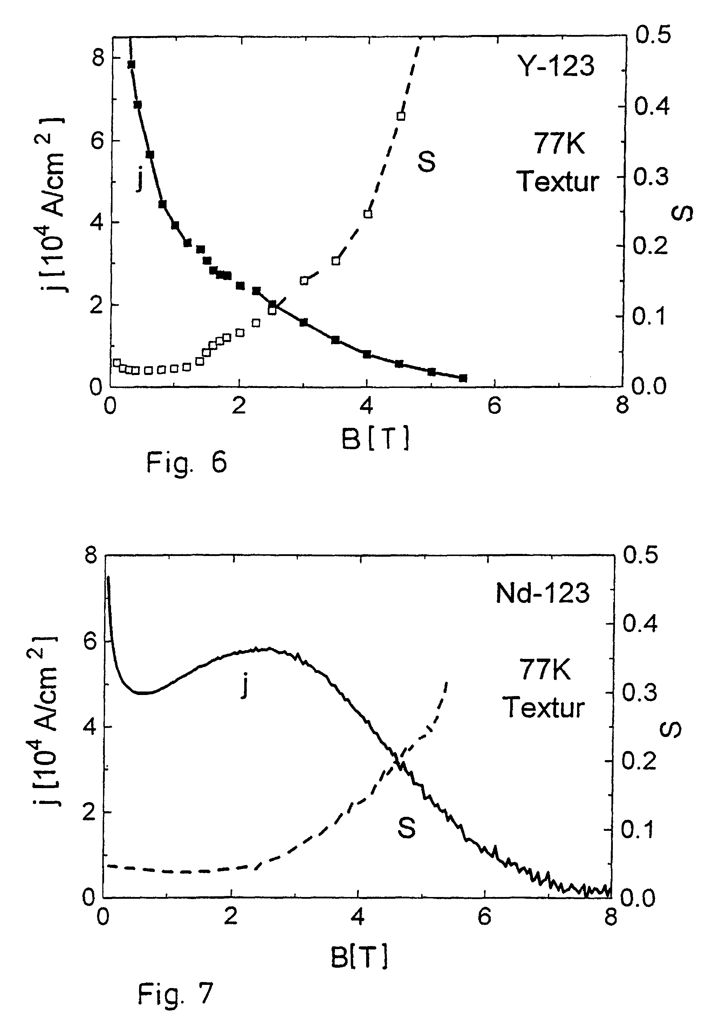

Aus der Gegenüberstellung der Relaxation S einer Y123- und einer Nd123-Schmelztexturprobe in Figur 6 (für Y123) und in Figur 7 (für Nd123) ist die Überlegenheit des Nd123 bezüglich technischer Verwendbarkeit klar zu erkennen. Bei vertretbaren S-Werten von 0,1 eignet sich Nd123 für die Anwendung bis zu Feldern von 3,5 T, während Y123 bis maximal 2,2 T eingesetzt werden kann. Bei strengen Anforderungen, S < 0,05 verringern sich diese maximalen Anwendungsfelder auf < 1,5 T für Y123 und auf 3,5 T für Nd123.

## Patentansprüche

1. Verfahren zur Züchtung von Hochtemperatursupraleiter(HTSL)-Einkristallen aus Seltenerd(SE)-Kupraten der Form $SE_{1+x}Ba_{2-x}Cu_3O_{7-\delta}$ (SE123) mit der SE/Ba-Fehlbesetzung x und der Sauerstoffreduktion und zur Verbesserung ihrer HTSL-Eigenschaften $T_c$ und $j_c$, bestehend aus den Schritten:

   i) Mischen eines SE-armen Startpulvers,
   ii) Kristallisation durch Wärmebehandlung,
   bei der zunächst die Wärmebehandlung in einer reduzierten Luftatmosphäre mit einem kurzen, etwa 3 - 10 h lang dauernden Aufschmelzprozeß der Startpulvermischung bei > 1050°C mit einer anschließenden schnellen Abkühlrate von etwa 20 K/h auf zirka 1040°C beginnt, und sich daran in einer Luftatmosphäre von 50 - 100 mbar die eigentliche Kristallisation des Einkristalls mit einer weiteren, jedoch kleinen Abkühlrate von < 1 K/h anschließt,
   iii) Oxidation mit Sauerstoffnormaldruckbeladung auf etwa $O_{6,95}$ durch erneute Wärmebehandlung,
   bei der das SE123-Kristallgefüge in einer 1 bar strömenden Sauerstoffatmosphäre erneut auf 600°C erhitzt wird, wodurch ein Anwachsen der Fehlbesetzung x in SE123 verhindert wird, da bei dieser Temperatur keine Kationendiffusion mehr erfolgt, und in 50°C-Stufen mit jeweils einer Haltezeit von 50 - 100 h auf 300°C abgekühlt, um mit Sauerstoff beladen zu werden,
   **dadurch gekennzeichnet, daß**
   iv) die Startpulvermischung in ihren Anteilen, bezogen auf die Gesamtmischung, folgendermaßen zusammengestellt wird:

   1 - 3 at% SE als $SE_1O_{3/2}$,
   27 - 56 at% Ba als BaO, $Ba(NO_3)_2$ oder $BaCO_3$,
   41 - 72 at% Cu als CuO,

   das sich im *BaO-CuO-SE$_2$O$_3$*-Phasendiagramm *im dreieckigen Gebiet BaO-Nd123-CuO* entsprechend *dem(Bereich III), der* für die Kristallisation ergiebig ist, ausdrückt, bzw. der Startpulvermischung wird zur Optimierung der Pinning-Eigenschaft Y123 oder SrO in jeweils 1 - 3 at% Sr und/oder 0 - 2 at% Y zugegeben,
   v) der Kristallisationsprozeß in einer Luftatmosphäre von 50 - 100 mbar abläuft, bei einer Temperatur von 950 - 930°C gestoppt und die verbliebene Restschmelze abgegossen oder durch Eintauchen einer hochporösen, für den Prozeß inerten Keramik, wie SE422 oder $ZrO_2$ oder $BaZrO_3$ oder $BaHfO_3$ oder $BaSnO_3$, aufgesogen wird,
   die so erzeugten SE123-Kristalle werden weiter zur Vermeidung einer Entmischung der 123-Phase mit einer Rate von 100 - 200 K/h auf Zimmertemperatur unter gleichzeitiger Reduzierung des Sauerstoffpartialdrucks $p_{O2}$ abgekühlt,
   vi) die SE123-Kristalle nach der Normaldruckbeladung erneut auf etwa 500°C aufgeheizt und in 50 °C-Stufen mit einer jeweiligen Haltezeit von 50 - 100 h in einer abgeschlossenen Sauerstoffatmosphäre von 100 - 300 bar (Sauerstoffbeladung) auf etwa 300°C abgekühlt werden, zur Einstellung des optimalen Stromdichteverlaufs in Abhängigkeit des Magnetfeldsj = f(B) der Sauerstoffgehalt durch Reduktionsbehandlung durch weiteres Erwärmen auf etwa 300 - 350°C in 1 bar durchfließender Sauerstoffatmosphäre während 60 - 70 h auf einen dafür maßgebenden Sauerstoffgehalt $O_{6,89 \text{ bis } 7}$ reduziert wird, an die sich ein natürliches Abkühlen auf Raumtemperatur anschließt.

2. Verfahren zur Züchtung von schmelztexturierten Quasieinkristallen von Hochtemperatursupraleitern (HTSL) aus Seltenerd(SE)-Kupraten der Form $SE_{1+x}Ba_{2-x}Cu_3O_{7-\delta}$ (SE123) mit der SE/Ba-Fehlbesetzung x und der Sauerstoffreduktion ( und zur Verbesserung ihrer HTSL-Eigenschaften $T_c$ und $j_c$, bestehend aus den Schritten:

   i) Startpulvermischen:

   aus synthetisiertem SE123-Pulver mit CuO- und BaO-Zusätzen derart, daß die Zusätze einen Summenanteil von größer 0 bis 20 at% bezogen auf die Gesamtmischung stellen, oder es wird die entsprechende Menge $BaCuO_2$ vorsynthetisiert,

   ii) Formgeben:

   die Startpulvermischung wird zu einem Pellet, dem Grünkörper, gepreßt,

   iii) Schmelztexturieren:

   der Grünkörper wird zunächst bei einer Temperatur von 950°C 1 - 2 Tage gesintert, zum Texturbeginn und zur orientierten Texturausbreitung wird ein MgO-Keim am kühleren Bereich des Pellets mit seiner Kristallausrichtung orientiert aufgesetzt,

das Pellet wird in einer reduzierten Luftatmosphäre auf > 1050°C erhitzt und 1/2 - 1 h auf dieser Temperatur gehalten,

eine rasche Abkühlung auf 1040°C mit einer Rate von ca 20 K/h folgt,

ein horizontaler Temperaturgradient von 1 - 10 K/cm wird dem Pellet überlagert,

mit einer folgenden kleinen Abkühlrate von 0,1 - 1 K/h zur Vermeidung von Neukeimbildung wird der eigentliche Schmelztexturprozeß eingeleitet,

iv) Oxidation:

das SE123-Kristallgefüge wird zur Verhinderung des Anwachsens von x in $SE_{1+x}Ba_{2-x}Cu_3O_{7-\delta}$ in einer 1 bar strömenden Sauerstoffatmosphäre erneut auf 600°C erhitzt, da bei dieser Temperatur keine Kationendiffusion mehr erfolgt, und es wird zur Beladung mit Sauerstoff in 50°C-Stufen mit jeweils einer Haltezeit von 50 - 100 h auf 300°C abgekühlt,

**dadurch gekennzeichnet, daß**

v) sich im *BaO-CuO-SE$_2$O$_3$*-Phasendiagramm der für die Schmelztextur ergiebige Bereich (II) in den *Schranken* von 55 -65% CuO, 35 - 45% BaO *und 13 - 17% SE123 liegt,* der Startpulvermischung zur Optimierung der Pinning-Eigenschaft y123 oder SrO in den Mengen 1 - 3 at% Sr und/oder 0 - 20 at% Y123 beigegeben wird, zur Verhinderung des Wegfließens eines zu hohen Schmelzanteils beim Texturprozeß Viskoseerhöher eingebracht werden,

Substanzen, sog. Perovskite, beigemengt werden, die mit der Ba/Cu-Schmelze nicht reagieren und im Supraleiter nicht löslich sind,

zur Verbesserung der Plastizität ebenfalls Substanzen, wie Perovskite oder Nichtperovskite, eingebracht werden, die mit der Ba/Cu-Schmelze nicht reagieren.

vi) *das Schmelztexturieren* in einer Luftatmosphäre ≤ 100 mbar abläuft, bei 950 - 910°C gestoppt und die Restschmelze mit einer für den Prozeß inerten Keramik, wie SE422 oder ZrO$_2$ oder BaZrO$_3$ oder BaHfO$_3$ oder BaSnO$_3$, durch Anlegen an die Texturprobe aufgesogen wird, die Texturprobe, das so erzeugte SE123-Kristallgefüge, mit einer Rate von 100 - 200 K/h auf Zimmertemperatur unter gleichzeitiger Reduzierung des Sauerstoffpartialdrucks p$_{02}$ zur Verhinderung einer Entmischung der SE123-Phase abgekühlt wird,

vii) die SE123-Kristalle nach der Normaldruckbeladung erneut auf etwa 500°C aufgeheizt und in 50°C-Stufen mit einer jeweiligen Haltezeit von 50 - 100 h in einer abgeschlossenen Sauerstoffatmosphäre von 100 - 300 bar (Sauerstoffhochdruckbeladung) auf etwa 300°C abgekühlt werden,

zur Einstellung des optimalen Stromdichteverlaufs in Abhängigkeit des Magnetfelds j = f(B) der Sauerstoffgehalt durch Reduktionsbehandlung durch weiteres Erwärmen auf etwa 300 - 350°C in 1 bar durchfließender Sauerstoffatmosphäre während 60 - 70 h auf einen dafür maßgebenden Sauerstoffgehalt $O_{6,89 \text{ bis } 7}$ reduziert wird, an die sich ein natürliches Abkühlen auf Raumtemperatur anschließt.

**3.** Verfahren nach Anspruch 2,
   **dadurch gekennzeichnet,**
   **daß** die Viskositätserhöher entweder BaZrO$_3$, BaHfO$_3$, BaSnO$_3$ bzw. deren entsprechende Vorstufen BaO + ZrO$_2$, BaO + HfO$_2$, BaO + SnO$_2$ oder CeO$_2$, Pt, PtO$_2$ sind.

**4.** Verfahren nach Anspruch 2,
   **dadurch gekennzeichnet, daß**
   die Plastizitätsverbesserer die Perowskite BaHfO$_3$ oder BaZrO$_3$ oder BaSnO$_3$ oder deren entsprechende Vorstufen BaO + ZrO$_2$, BaO + HfO$_2$, BaO + SnO$_2$ oder die Nichtperowskite wie Ag oder Ag$_2$O sind.

**5.** Verfahren nach Anspruch 1 und 4,
   **dadurch gekennzeichnet, daß**
   nur SE-Metalle, wie La oder Nd oder Sm oder Eu oder Gd, verwendet werden, die auch die Tendenz haben, den Ba-Platz zu besetzen.

**Claims**

**1.** Method for growing high-temperature superconductor (HTSC) monocrystals from rare earth (RE) cuprates in the form $RE_{1+x}Ba_{2-x}Cu_3O_{7-\delta}$ (RE123) with the RE/Ba dislocation x and reduction of oxygen and to improve its HTSC properties T$_c$ and j$_c$, comprising the steps:

   i) mixing an initial powder which is low in rare earth,
   ii) crystallisation by heat treatment,
   in which initially the heat treatment begins in a reduced air atmosphere with a short melting process for the initial powder mixture, lasting for roughly 3 to 10 h at > 1050°C followed by a rapid cooling rate of roughly 20 K/h to approx. 1040°, and
   this is followed in an air atmosphere of 50 to 100 mbar by the actual crystallisation of the monocrystal at a further but low cooling rate of < 1 K/h,

iii) oxidation with normal oxygen pressure loading to roughly $O_{6,95}$ through renewed heat treatment,

in which the RE123 crystal structure is heated again to 600°C in an oxygen atmosphere flowing at 1 bar, by which means accretion of the dislocation x in RE123 is prevented since there is no longer cation diffusion at this temperature, and is cooled to 300°C in 50°C-stages each having a holding time of 50 to 100 h, in order to be loaded with oxygen,

**characterised in that**

iv) the initial powder mixture is composed with the following proportions in relation to the total mixture:

1 - 3 at% RE as $RE_1O_{3/2}$,
27 - 56 at% Ba as BaO, $Ba(NO_3)_2$ or $BaCO_3$,
41 - 72 at% Cu as CuO,

which is expressed in the $BaO$-$CuO$-$RE_2O_3$ phase diagram in the triangular region BaO-Nd123-CuO corresponding to (Region III), which is productive for crystallisation, or respectively, to optimise the Pinning property, Y123 or SrO is added to the initial powder mixture with respectively 1 to 3 at% Sr and/or 0 to 2 at% Y,

v) the crystallisation process takes place in an air atmosphere of 50 to 100 mbar, at a temperature of between 950°C and 930°C, and the remaining residual melt is poured off or soaked up by dipping into it a highly porous ceramic material which is inert for the process, such as RE422 or $ZrO_2$ or $BaZrO_3$ or $BaHfO_3$ or $BaSnO_3$,

the RE123 crystals thus produced are then cooled further to room temperature, to avoid demixing of the 123 phase, at a rate of 100 to 200 K/h to room temperature with simultaneous reduction of the partial oxygen pressure $p_{02}$,

vi) after normal pressure loading, the RE123 crystals are heated up again to roughly 500°C and are cooled to roughly 300°C in 50°C-stages, each having a holding time of 50 to 100 h, in a sealed oxygen atmosphere of 100 to 300 bar (oxygen loading),

to set the optimal current density course in dependence on the magnetic field j = f(B), the oxygen content is reduced by a reduction process through further heating to roughly 300 to 350°C in an oxygen atmosphere flowing through at 1 bar for 60 to 70 h to an oxygen content $O_{6,89\ to\ 7}$ standard for this, after which there is natural cooling to room temperature.

2. Method for growing melt-textured high-temperature superconductor (HTSC) monocrystals from rare earth (RE) cuprates in the form $RE_{1+x}Ba_{2-x}Cu_3O_{7-\delta}$ (RE123) with the RE/Ba dislocation x and reduction of oxygen, and to improve its HTSC properties $T_c$ and $j_c$, comprising the steps:

i) mixing the initial powder;
from synthesised RE123 powder with CuO and BaO additives in such a way that the additives represent a total proportion of more than 0 to 20 at% in relation to the total mixture, or the corresponding amount $BaCuO_2$ is pre-synthesised,

ii) shaping:

the initial powder mixture is pressed to form a pellet,

iii) melt-texturing:

the green body is first sintered at a temperature of 950°C for 1 to 2 days,
at the beginning of the texturing and for oriented texture spreading, an MgO nucleus is placed at the cooler region of the pellet orientated with its crystal alignment,
the pellet is heated in a reduced air atmosphere to > 1050°CC and held at this temperature for 1/2 h to 1 h,
rapid cooling to 1040°C at a rate of approx. 20 K/h follows,
a horizontal temperature gradient of 1 to 10 K/cm is superimposed on the pellet,
the actual melt-texturing process is initiated with a following low cooling rate of 0.1 to 1 K/h to avoid any new formation of nuclei,

iv) oxidation:

the RE123 crystal structure, to prevent the accretion of x in $RE_{1+x}Ba_{2-x}Cu_3O_{7-\delta}$, is heated again to 600°C in an oxygen atmosphere flowing at 1 bar since there is no longer cation diffusion at this temperature, and
for loading with oxygen, it is cooled to 300°C in 50°C-stages each having a holding time of 50 to 100 h,

**characterised in that**

v) in the $BaO$-$CuO$-$RE_2O_3$ phase diagram, the productive region (II) for the melt-texturing lies within the limits 55-65% CuO, 35-45% BaO and 13-17% RE123,
to optimise the Pinning property, Y123 or SrO is added to the initial powder mixture in the amounts 1 to 3 at% Sr and/or 0 to 20 at% Y123,

viscosity-increasing agents are introduced to prevent too high a proportion of the melt from flowing away during the texturing process, substances, so-called perovskites, are added which do not react with the Ba/Cu melt and are not soluble in the superconductor,
to improve the plasticity, substances, such as perovskites or non-perovskites, are also introduced which do not react with the Ba/Cu melt.
vi) the melt-texturing takes place in an air atmosphere $\leq$ 100 mbar, is halted at 950°C to 910°C and the residual melt is sucked up with a ceramic material which is inert for the process, such as RE422 or $ZrO_2$ or $BaZrO_3$ or $BaHfO_3$ or $BaSnO_3$, by laying it against the textured sample,
the textured sample, the RE123 crystal structure thus produced, is cooled to room temperature at a rate of 100 to 200 K/h with simultaneous reduction of the partial oxygen pressure $p_{02}$ to prevent demixing of the RE123 phase,
vii) the RE123 crystals, after normal pressure loading, are heated up again to roughly 500°C and are cooled to roughly 300° in 50°C-stages each having a holding time of 50 to 100 h in a sealed oxygen atmosphere of 100 to 300 bar (high oxygen pressure loading),
to set the optimal current density course in dependence on the magnetic field $j = f(B)$, the oxygen content is reduced by a reduction process through further heating to roughly 300 to 350°C in an oxygen atmosphere flowing through at 1 bar for 60 to 70 h to an oxygen content $O_{6,89 \text{ to } 7}$ standard for this, after which there is natural cooling to room temperature.

3. Method according to claim 2,
   **characterised in that**
   the viscosity-increasing agents are either $BaZrO_3$, $BaHfO_3$, $BaSnO_3$ or respectively their corresponding precursors $BaO + ZrO_2$, $BaO + HfO_2$, $BaO + SnO_2$ or $CeO_2$, Pt, $PtO_2$.

4. Method according to claim 2,
   **characterised in that**
   the plasticity improvers are the perovskites $BaHfO_3$ or $BaZrO_3$ or $BaSnO_3$ or their corresponding precursors $BaO + ZrO_2$, $BaO + HfO_2$, $BaO + SnO$ or the non-perovskites such as Ag or $Ag_2O$.

5. Method according to claim 1 and 4,
   **characterised in that**
   only rare earth metals such as La or Nd or Sm or Eu or Gd are used which also have a tendency to occupy the Ba place.

**Revendications**

1. Procédé de culture de monocristaux supraconducteurs à haute température (HTSL) à partir dé cuprate de terres rares (SE) de la forme $SE_{1+x}Ba_{2-x}Cu_3O_{7-\delta}$ (SE123), avec la mauvaise population Se/Ba x et la réduction d'oxygène ainsi que pour l'amélioration de leurs caractéristiques HTSL $T_c$ et $j_c$, et qui consiste en plusieurs étapes:

   i) Mélange d'une poudre de départ pauvre en SE,

   ii) Cristallisation par traitement thermique,
   le traitement thermique commençant d'abord dans une atmosphère d'air réduite par un processus de fusion de courte durée de 3 - 10 h environ du mélange de poudre de départ à > 1050°C, suivi d'un taux de refroidissement rapide d'environ 20 K/h jusqu'à environ 1040°C, après lequel, dans une atmosphère d'air de 50 - 100 mbar, la cristallisation proprement dite du monocristal suit à un autre taux de refroidissement plus petit de < 1 K/h,

   iii) Oxydation à pression d'oxygène normale à environ $O_{6,95}$ par un nouveau traitement thermique où la structure cristalline de SE123 est à nouveau chauffée à 600°C dans une atmosphère d'oxygène circulant à 1 bar, ce qui empêche la croissance de la mauvaise population x dans SE123, une diffusion cationique n'ayant plus lieu à cette température, suivi d'un refroidissement à 300°C à des pas de 50°C et des temps d'arrêt à chaque pas de 50 - 100 h, pour être chargé d'oxygène,
   **caractérisé en ce que**

   iv) le mélange de poudre de départ est préparé aux teneurs suivantes par rapport au mélange total:

   1 - 3% at. de SE comme $Se_1O_{3/2}$,
   27 - 56% at. de Ba comme BaO, $Ba(No_3)_2$ ou $BaCo_3$,
   41 - 72% at. de Cu comme CuO,

   qui dans le diagramme de phase $BaO-CuO-SE_2O_3$ dans le domaine triangulaire BaO-Nd123-CuO s'exprime selon le domaine (domaine III) qui est productif pour la cristallisation, ou, respectivement, pour l'optimisation de la caractéristique de pinning, Y123 ou SrO est ajouté au mélange de poudre de départ à raison de 1 - 3% at. de Sr et/ou 0 - 2% at. de Y,

   v) le processus de cristallisation se déroule dans une atmosphère d'air de 50 - 100 mbar pour être arrêté à une température de 950 - 930°C, la masse fondue résiduelle étant versée ou absorbée par immersion d'une céramique hautement poreuse, inerte pour le processus, telle que SE422 ou $ZrO_2$ ou $BaZrO_3$ ou $BaHfO_3$ ou $BaSnO_3$,

pour éviter une dissociation de la phase 123, les cristaux de SE123 ainsi produits sont encore refroidis à la température ambiante, à un taux de 100 - 200 k/h tout en réduisant la pression partielle d'oxygène $p_{02}$,

vi) suite à l'application de la pression normale, les cristaux de SE123 sont à nouveaux chauffés à environ 500°C et refroidies à environ 300°C, à des pas de 50°C, avec un temps d'arrêt pour chaque pas de 50 - 100 h, dans une atmosphère d'oxygène isolée de 100 - 300 bar (oxygénation),

que pour régler l'évolution optimale de la densité de courant en fonction du champ magnétique $j = f(B)$, la teneur en oxygène est réduite par traitement réducteur consistant en un échauffement supplémentaire à environ 300 - 350°C dans une atmosphère d'oxygène circulant à 1 bar pendant 60 - 70 h, jusqu'à une teneur en oxygène déterminante $O_{6, 89 \text{ à } 7}$, suivi d'un refroidissement naturel à la température ambiante.

2. Procédé de culture de quasi monocristaux texturés par fusion de supraconducteurs à haute température (HTSL) à partir de cuprates de terres rares (SE) de la forme $Se_{1+x}Ba_{2-x}Cu_3O_{7-\delta}$ (Se123) avec la mauvaise population SE/Ba x et la réduction d'oxygène (et pour l'amélioration de leurs caractéristiques HTSL $T_c$ et $j_c$) consistant en plusieurs étapes:

    i) Mélange de la poudre de départ:

        de poudre synthétique SE123 et d'additions de CuO et de BaO telles que les additions représentent une part cumulée supérieure à 0 jusqu'à 20% at. par rapport au mélange total, ou bien en effectuant une synthétisation préalable de la quantité correspondante de $BaCuO_2$,

    ii) Formage:

        le mélange de poudre de départ est comprimé en une pastille, le corps vert,

    iii) Texture par fusion:

        le corps vert est d'abord fritté pendant 1 - 2 jours à une température de 950°C, au début de la texture et pour obtenir une extension orientée de la texture, un germe de MgO est posé sur la partie plus froide de la pastille, en l'orientant selon son orientation cristalline,

la pastille est chauffée à > 1050°C dans une atmosphère d'air réduite et maintenue à cette température pendant 1/2 - 1 h, on fait suivre un refroidissement rapide à 1040°C à un taux d'environ 20 K/h, un gradient de température horizontal de 1 - 10 K/cm est superposé à la pastille, en faisant suivre un taux de refroidissement plus petit de 0,1 - 1 K/h pour éviter la formation de nouveaux germes, on déclenche le processus de texture par fusion proprement dit,

iv) Oxydation:

    pour empêcher la croissance de x dans $SE_{1+x}Ba_{2-x}Cu_3O_{7-\delta}$, la structure cristalline de SE123 est à nouveau chauffée à 600°C, dans une atmosphère d'oxygène circulant à 1 bar, puisqu'à cette température il n'y a plus de diffusion cationique, et pour l'oxygénation par pas de 50°C, on effectue le refroidissement à 300°C, avec un temps d'arrêt de 50 - 100 h pour chaque pas.

**Caractérisé en ce que**

v) dans le diagramme de phase $BaO\text{-}CuO\text{-}SE_2O_3$, le domaine productif pour la texture par fusion (II) se situe dans les limites de 55 - 65% CuO, 35 - 45% BaO et 13 - 17% SE123, que pour l'optimisation de la caractéristique de pinning, on ajoute de l'Y123 ou du SrO au mélange de poudre de départ, à raison de 1 -3 % at. de Sr et/ou 0 - 20% at. de l'Y123,

pour éviter qu'une trop grande partie de la masse fondue ne s'écoule lors du processus de texture, on introduit des substances augmentant la viscosité,

on ajoute des substances appelées perovskites, qui ne réagissent pas avec la masse fondue de Ba/Cu et qui ne sont pas solubles dans le supraconducteur,

pour améliorer la plasticité, on introduit aussi des substances telles que des perovskites ou des non-perovskites qui ne réagissent pas avec la masse fondue de Ba/Cu.

vi) La texture par fusion se déroule dans une atmosphère d'air $\leq 100$ mbar, qu'elle est arrêtée à 950 - 910°C et que la matière fondue résiduelle est absorbée par une céramique inerte pour le processus telle que SE422 ou $ZrO_2$ ou

$BaZrO_3$ ou $BaHfO_3$ ou $BaSnO_3$, posée sur l'échantillon de texture, que l'échantillon de texture, la structure cristalline de SE123 ainsi produite, est refroidie à la température ambiante à un taux de 100 - 200 K/h, tout en réduisant la pression partielle d'oxygène $p_{02}$ pour empêcher la dissociation de la phase SE123,

vii) les cristaux de SE123, après application de la pression normale, sont à nouveaux chauffés à environ 500°C et refroidies à environ 300°C par pas de 50°C, avec un temps d'arrêt pour chaque pas de 50 - 100 h, dans une atmosphère d'oxygène isolée de 100 - 300 bar (oxygénation à haute pression),
pour régler l'évolution optimale de la densité de courant en fonction du champ magnétique j = f (B), la teneur en oxygène est réduite à une teneur déterminante de $O_{6,89\ à\ 7}$, par traitement de réduction en chauffant encore à environ 300 - 350°C dans une atmosphère d'oxygène circulant à 1 bar pendant 60 - 70 h, suivi d'un refroidissement naturel à la température ambiante.

3. Procédé selon la revendication 2,
   **caractérisé en ce que**
   la substance augmentant la viscosité est ou $BaZrO_3$, ou $BaHfO_3$, ou $BaSnO_3$ ou leurs progéniteurs respectifs, $BaO + ZrO_2$, $BaO + HfO_2$, $BaO + SnO_2$ ou $CeO_2$, $Pt$, $PtO_2$.

4. Procédé selon la revendication 2,
   **caractérisé en ce que**
   les substances améliorant la plasticité sont les perovskites $BaHfO_3$ ou $BaZrO_3$ ou $BaSnO_3$ ou leurs progéniteurs respectifs, $BaO + ZrO_2$, $BaO + HfO_2$, $BaO + SnO_2$ ou les non-perovskites telles que $Ag$ ou $Ag_2O$.

5. Procédé selon les revendications 1 et 4,
   **caractérisé en ce que**
   seuls des métaux de terres rares sont utilisés, tels que La ou Nd ou Sm ou Eu ou Gd, qui ont également la tendance d'occuper la position de Ba.

Fig. 1

Fig. 2

Fig. 3

Fig. 4

## Fig. 5

Fig. 6

Fig. 7